(19) **Europäisches Patentamt**

**European Patent Office**

**Office européen des brevets**

(11) **EP 0 738 031 B1**

(12) **EUROPEAN PATENT SPECIFICATION**

(45) Date of publication and mention
of the grant of the patent:
**18.07.2001 Bulletin 2001/29**

(51) Int Cl.⁷: **H01S 3/0941**, H01S 3/109

(21) Application number: **96110043.5**

(22) Date of filing: **20.05.1994**

(54) **A short wavelength light source apparatus**

Vorrichtung mit kurzwelliger Lichtquelle

Appareil avec source de lumière à courte longueur d'onde

(84) Designated Contracting States:
**DE FR**

(30) Priority: **21.05.1993 JP 11974293**
**01.10.1993 JP 24652993**
**04.10.1993 JP 24788393**

(43) Date of publication of application:
**16.10.1996 Bulletin 1996/42**

(62) Document number(s) of the earlier application(s) in
accordance with Art. 76 EPC:
**94107841.2 / 0 625 811**

(73) Proprietor: **MATSUSHITA ELECTRIC INDUSTRIAL
CO., LTD.**
**Kadoma-shi, Osaka 571-8501 (JP)**

(72) Inventors:
• **Kitaoka, Yasuo**
**Kawachinagano-shi, Osaka (JP)**
• **Yamamoto, Kazuhisa**
**Settsu-shi, Osaka (JP)**
• **Kato, Makoto**
**Nishinomiya-shi, Hyogo-ken (JP)**

(74) Representative: **Marx, Lothar, Dr.**
**Patentanwälte Schwabe, Sandmair, Marx
Stuntzstrasse 16
81677 München (DE)**

(56) References cited:
**EP-A- 0 559 139**

• **OPTICS LETTERS, 1 JAN. 1993, USA, vol. 18, no.
1, ISSN 0146-9592, pages 34-36, XP000328271
STEPHENS R R ET AL: "Diode-pumped
upconversion laser with 100 mW output power"**
• **APPLIED PHYSICS LETTERS, 19 JULY 1993,
USA, vol. 63, no. 3, ISSN 0003-6951, pages
299-301, XP000382577 KITAOKA Y ET AL:
"Stable and efficient green light generation by
intracavity frequency doubling of Nd:YVO/sub 4/
lasers"**
• **OPTICS LETTERS, OCT. 1988, USA, vol. 13, no.
10, ISSN 0146-9592, pages 826-828,
XP000050989 ZORABEDIAN P ET AL:
"Interference-filter-tuned, alignment-stabilized,
semiconductor external-cavity laser"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

## BACKGROUND OF THE INVENTION

1. Field of the Invention:

The present invention relates to a light source apparatus for use in a high-density optical disk system and the like, and particularly to a short wavelength light source apparatus incorporating a semiconductor laser as a pump light source.

2. Description of the Related Art:

In the field of high density recording using optical disks and image processing, there has been a need for light source apparatuses which incorporate semiconductor lasers as pump light sources and which provide green light or blue light by converting light emitted from the semiconductor lasers into light having different wavelengths. Such a light source apparatus is required to satisfy the following stipulations.

1) The output light has a Gaussian light intensity distribution in the lateral direction, and light can be focused at the diffraction limit.

2) The optical power of the output light is on the order of a few mW (milliwatts), and the operation is stable both in terms of the generated frequency and as a function of time.

In order to obtain a short wavelength light source apparatus having an output power of a few mW or more with a semiconductor laser incorporated as a pump light source, a method for directly converting the wavelength of semiconductor laser light is regarded as promising. The method typically uses, as an optical wavelength converting element, a polarization inversion type optical waveguide element of a quasi-phase matching (hereinafter referred to as "QPM") type using $LiTaO_3$, $LiNbO_3$, and $KTiOPO_4$ as a substrate (Yamamoto et al.; Optics Letters Vol.16, No.15, 1156 (1991)), a polarization inversion type bulk element, and/or a phase matching type non-linear optical crystal having a large non-linear optical constant, e.g. $KNbO_3$(KN).

Also regarded as promising are intracavity type short wavelength light source apparatuses incorporating cavities internalizing laser media. In such a light source apparatus, a laser medium receives laser light generated by a semiconductor laser (pump light source) so as to effect laser oscillation, and generates laser light having a longer wavelength than that of the laser light from the semiconductor laser. The generated laser light is converted into short-wavelength light (harmonics) by an optical wavelength converting element inserted in the interior of a resonator.

First, a direct wavelength conversion method using a polarization inversion type waveguide element will be described. Currently, in devices incorporating polarization inversion type waveguide element of the QPM type, blue light having an optical output power of 1.1 mW is obtained under the condition that light emitted from a semiconductor laser and entering the polarization inversion type waveguide has an intensity of 35 mW. However, while the QPM polarization inversion type waveguide element having an allowable range of wavelength variation of only 0.2 nm, the light oscillated by the semiconductor laser has a fluctuation as large as 0.2 nm/°C against temperature changes. Moreover, since there is a mode hopping of about 1 nm due to light returning to the semiconductor laser, the output of the QPM polarization inversion type waveguide element can be stable for a time period of only several seconds. Phase matching type non-linear optical crystals and QPM polarization inversion type bulk elements similarly have a relatively narrow range of allowable wavelength variation with respect to phase matching. This increases the importance of stabilization of the oscillation wavelength of a semiconductor laser used as a pump light source.

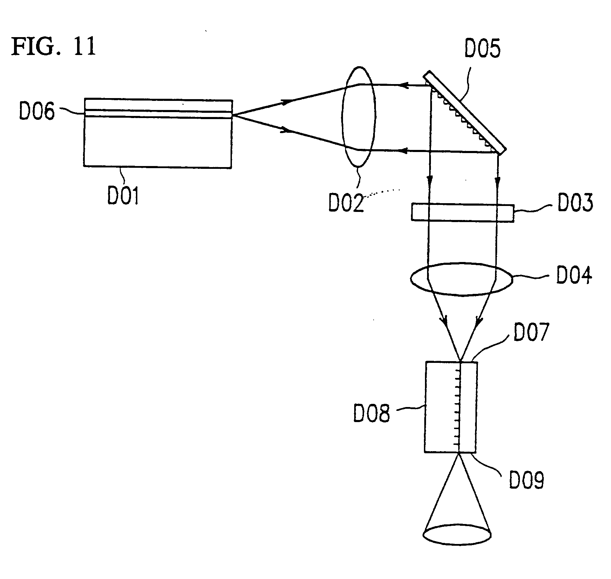

With a view to stabilizing the oscillation wavelength of a light generating apparatus incorporating a semiconductor laser as a pump light source, there has been proposed a short wavelength light source apparatus in which a grating is provided by the end of a semiconductor laser through which laser light goes out. The general configuration of this conventional short wavelength light source apparatus will be described with reference to Figure **11.**

In Figure 11, reference numeral **D01** denotes a 50 mW-class AlGaAs semiconductor laser for the 0.83 μm band; **D02** denotes a collimating lens; **D03** denotes a λ/2 plate; **D04** denotes a focusing lens having a numerical aperture (hereinafter referred to as "N.A.") of 0.6; and **D05** denotes a grating disposed at an angle of θ with the optical axis of the semiconductor laser **D01.** The grating **D05** has a linear shape. A high reflectance coating is formed on an end face **D06** of the semiconductor laser **D01.** The grating **D05** has a wavelength dispersing effect, and therefore is capable of locking the oscillation wavelength of the semiconductor laser **D01** by feeding back light of a certain wavelength to the semiconductor laser **D01** as a first-order diffracted light. Laser light (wavelength: 830 nm) reflected from the grating **D05** is incident to the λ/2 plate **D03,** which rotates the polarizing direction of the laser light, and is lead through a focusing lens **D04** so as to be focused on an end face **D07** of the polarization inversion type waveguide element **D08.** Light propagated through the polarization inversion type waveguide element **D08** having polarization-inverted layers (period: 3.7 μm) is converted into light with a wavelength of 415 nm so as to go out through an end face **D09.** An antireflection (AR) coating which does not reflect the fundamental wave is provided on each of the end faces **D07** and **D09.** The polarization inversion type waveguide element **D08** is formed on an LiTaO$_3$ substrate.

Next, a solid laser incorporating a semiconductor laser as a pump light source will be described.

With the use of an intracavity type solid laser, green light having an optical output power of about 3 mW has been conventionally obtained by wavelength conversion with KTP (KTiOPO$_4$) when the semiconductor laser has a pumping intensity of 50 mW for Nd:YVO$_4$. However, the half-width of the absorption spectrum of a laser material of Nd:YVO$_4$ is a few nm (nanometers). Therefore, presence of a mode hopping and multiplication of the longitudinal mode may cause output noises. This makes it mandatory to stabilize the oscillation wavelength of the semiconductor laser.

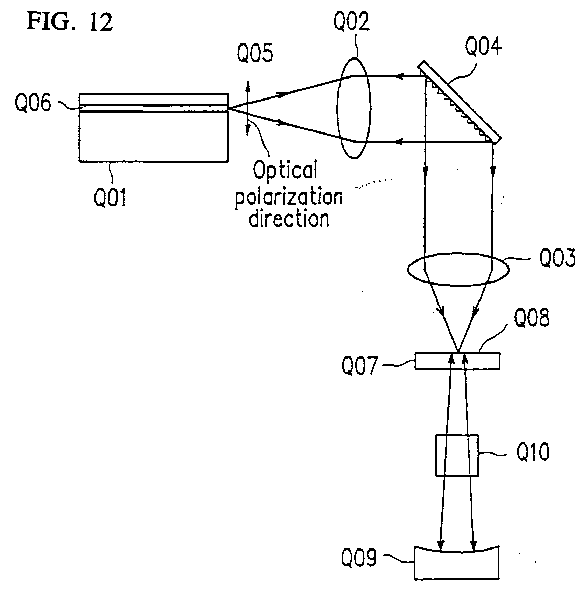

In the field of light generating apparatuses incorporating semiconductor lasers capable of oscillation in a single longitudinal mode as pump light sources, there has been proposed a short wavelength light source apparatus in which a grating is provided by the end of a semiconductor laser through which laser light goes out. The general configuration of this conventional short wavelength light source apparatus will be described with reference to Figure **12**.

In Figure **12**, reference numeral **Q01** denotes a 60 mW-class AlGaAs semiconductor laser for the 809 nm band; **Q02** denotes a collimating lens; **Q03** denotes a focusing lens (f:14.5 mm); **Q04** denotes a grating disposed at an angle of θ with the optical axis of the semiconductor laser **Q01.** The grating **Q04** has a linear shape. A diffraction efficiency of about 10% was obtained under the following conditions: the incident angle was 30°; the depth was 0.29 μm; and the pitch was 0.83 μm. The grating **Q04** has a wavelength dispersing effect, and therefore is capable of locking the oscillation wavelength of the semiconductor laser **Q01** by feeding back light of a certain wavelength to the semiconductor laser **Q01** as a first-order diffracted light. Laser light (zero-order diffracted light) reflected from the grating **Q04** is lead through the focusing lens **Q03** so as to be focused on an end face **Q08** of a laser medium of Nd:YVO$_4$ **Q07.** The fundamental wave, resonated between an output mirror **Q09** and the end face **Q08** of the Nd:YVO$_4$ laser medium **Q07** is subjected to wavelength conversion by a non-linear device optical crystal of KTP (KTiOPO$_4$) **Q10** so as to be output through the output mirror **Q09**.

As is seen from Figures 11 and 12 when attempting to stabilize the longitudinal mode oscillation of a semiconductor laser with the use of a grating, the stability may be drastically lowered due to temporal change of the grating and/or the posture in which it is maintained and change in the surrounding temperature. The grating angle dependence of the wavelength stability is 28 nm/deg.

Moreover, the whole module (apparatus) cannot be configured in a linear shape because the optical axis of the semiconductor laser is bent with respect to the optical axis of the emitted light. Therefore, miniaturization of such a short wavelength light source apparatus becomes difficult.

Furthermore, use of a grating for adjustments against changes in the refractive index due to temperature changes of the optical wavelength converting element and/or optical damage, that is, changes in the phase matching wavelength, requires a complicated and high-precision adjustment mechanism.

In OPTICS LETTERS, Vol. 18, No. 1, Jan. 1993, pages 34 to 36 a high-power semiconductor diode-laser array operating at 797 nm is described to pump an Er:YLiF$_4$ upconversion laser with output at 551 nm operating at 48K.

A short wavelength light source apparatus, according to the present invention as defined in claim 1 comprises: a semiconductor laser including an active layer for emitting laser light; and a laser medium for receiving at least a portion of the laser light emitted from the semiconductor laser and for conducting laser oscillation by being excited by at least a portion of the laser light, wherein the short wavelength light source apparatus further comprises: an optical element for selectively reflecting a portion of the laser light that belongs to a predetermined wavelength band while transmitting another portion of the laser light to the laser medium and feeding back the reflected portion of the laser light to the active layer of the semiconductor laser to stabilise the oscillation wavelength within the absorption spectrum of the laser medium, the optical element being disposed between the semiconductor laser and the laser medium.

Alternatively, a short wavelength light source apparatus as defined in claim 7 comprises: a semiconductor laser including an active layer for emitting laser light; and a laser medium for receiving at least a portion of the laser light emitted from the semiconductor laser and for conducting laser oscillation by being excited by at least a portion of the laser light, wherein the short wavelength light source apparatus further comprises an optical element for selectively transmitting a portion of the laser light that belongs to a predetermined wavelength band, the optical element being disposed between the semiconductor laser and the laser medium, and the semiconductor laser and the laser medium being disposed in such a manner that a part of the portion of the laser light transmitted through the optical element is reflected by an incident end face of the laser medium so as to be transmitted back through the optical element and fed back to the active layer of the semiconductor laser to stabilise the oscillation wavelength within the absorption spectrum of the laser medium.

Alternatively, a short wavelength light source apparatus as defined in claim 17 comprises: a semiconductor laser including an active layer for emitting laser light; and a laser medium for receiving at least a portion of the laser light emitted from the semiconductor laser and for conducting laser oscillation by being excited by at least a portion of the laser light, wherein the short wavelength light source apparatus further comprises an optical element for selectively transmitting a portion of the laser light that belongs to a predetermined wavelength band, the optical element being disposed between the semiconductor laser and the laser medium being disposed in such a manner that a part of the portion of the laser light transmitted through the optical element enters the laser medium at the incident end face thereof and thereafter a portion of said part is reflected by an outgoing end face of the laser medium so as to be transmitted back through the optical element and fed back to the active layer of the semiconductor laser to stabilise the oscillation wavelength within the absorption spectrum of the laser medium.

In one embodiment of the invention, the optical element is a Bragg's reflective type thin film optical element comprising dielectric layers having different refrative indices, the dielectric layers being formed with a predetermined period.

In another embodiment of the invention, the optical element is a thin film optical element including a substrate and a dielectric multilayer film formed on the substrate.

In still another embodiment of the invention, the optical element comprises a dielectric multilayer film formed on an incident end face or an outgoing end face of at least one of the semiconductor laser and the optical wavelength converting element.

In still another embodiment of the invention, the short wavelength light source apparatus further comprises more than one optical element besides the optical element.

In still another embodiment of the invention, the optical element is disposed at an angle with an optical axis of the semiconductor laser.

In still another embodiment of the invention, the short wavelength light source apparatus further comprises a rotation mechanism for rotating the optical element.

In still another embodiment of the invention, the rotation mechanism includes a feedback circuit for controlling an output power of the short wavelength light to be constant.

In still another embodiment of the invention, the rotation mechanism includes a piezo element.

In still another embodiment of the invention, the short wavelength light source apparatus further comprises an optical wavelength converting element.

Thus, the invention described herein makes possible an advantage of providing a short wavelength light source apparatus capable of stably emitting short wavelength light by highly efficiently converting light generated by a semiconductor laser.

This and other advantages of the present invention will become apparent to those skilled in the art upon reading and understanding the following detailed description with reference to the accompanying figures.

Figure 1 is a view showing a semiconductor-laser-excited solid laser short wavelength light source apparatus according to the present invention incorporating a thin film optical element (reflective type filter) stabilizing the oscillation wavelength of the semiconductor laser.

Figure 2 is a graph showing a reflection spectrum of a thin film optical element (reflective type filter) according to the present invention.

Figure 3 is a view showing a semiconductor-laser-excited solid laser short wavelength light source apparatus according to the present invention incorporating a thin film optical element (reflective type filter) stabilizing the oscillation wavelength of the semiconductor laser.

Figure 4 is a view showing a semiconductor-laser-excited intracavity type short wavelength light source apparatus according to the present invention incorporating a thin film optical element (reflective type filter) stabilizing the oscillation wavelength of the semiconductor laser.

Figure 5 is a view showing a semiconductor-laser-excited solid laser short wavelength light source apparatus according to the present invention incorporating a thin film optical element (transmission type filter) stabilizing the oscillation wavelength of the semiconductor laser.

Figure 6 is a graph showing a transmission spectrum of a thin film optical element (transmission type filter) according to the present invention.

Figure 7 is a view showing a semiconductor-laser-excited solid laser short wavelength light source apparatus according to the present invention incorporating a thin film optical element (transmission type filter) stabilizing the oscillation wavelength of the semiconductor laser.

Figure 8 is a view showing a semiconductor-laser-excited intracavity type short wavelength light source apparatus according to the present invention incorporating a thin film optical element (transmission type filter) stabilizing the oscillation wavelength of the semiconductor laser.

Figure 9 is a view showing a semiconductor-laser-excited intracavity type short wavelength light source apparatus according to the present invention incorporating a thin film optical element (transmission type filter) stabilizing the oscillation wavelength of the semiconductor laser.

Figure 10A is a view showing a short wavelength light source apparatus according to the present invention in which a dielectric multilayer film is provided on an outgoing end face of a semiconductor laser.

Figure 10B is a view showing a short wavelength light source apparatus according to the present invention in which a dielectric multilayer film is provided on an incident end face of a laser medium.

Figure 10C is a view showing a short wavelength light source apparatus according to the present invention in which a dielectric multilayer film is provided on an outgoing end face of a laser medium.

Figure 11 is a view showing a conventional short wavelength light source apparatus incorporating a semiconductor laser and a polarization inversion type waveguide element, in which grating feedback technique is used.

Figure 12 is a view showing a conventional short wavelength light source apparatus incorporating a semiconductor laser and an intracavity type solid laser, in which grating feedback technique is used.

DESCRIPTION OF THE PREFERRED EMBODIMENTS

Hereinafter, the present invention will be described by way of examples, with reference to the accompanying drawings.

Example 1

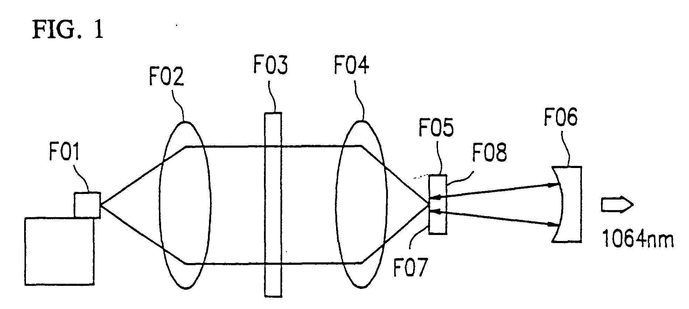

A short wavelength light source apparatus according to a first example of the present invention will be described with reference to Figure 1.

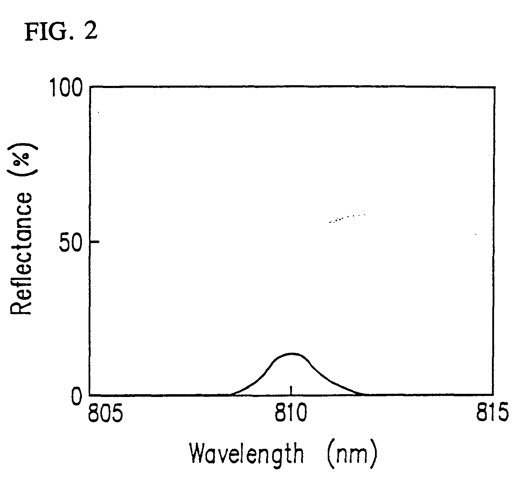

A band-stop type (reflective type) filter including a dielectric multilayer film is used as a thin film optical element F03 in the present example. Specifically, the thin film optical element F03 is composed essentially of a dielectric material such a $SiO_2$ and $TiO_2$ layered on a glass substrate (thickness: 0.5 mm). Figure 2 shows reflection characteristics of the thin film optical element F03. The reflectance of the thin film element F03 for light having a wavelength of 809 nm is about 10 % when the light perpendicularly enters the thin film element F03. By using such a band-stop type filter as the thin film optical element F03, stabilization of the oscillation wavelength and adjustment of the optical system are facilitated, since the distance between an outgoing end face of a semiconductor laser F01 and the thin film optical element F03 can be small.

Reference numeral F01 denotes a 100 mW-class single longitudinal mode semiconductor laser having an oscillation wavelength in the 810 nm band; F02 denotes a collimating lens (N.A.: 0.5); and F04 denotes a focusing lens for coupling light to a laser medium Nd: $YVO_4$ F05. Light emitted from the semiconductor laser **F01** and collimated by the collimating lens **F02** is led through the thin film optical element **F03,** which is disposed perpendicularly to the optical axis of the semiconductor laser **F01.** The thin film optical element **F03** feeds back a portion of light having a wavelength in the vicinity of 809 nm to an active layer of the semiconductor laser **F01.** The thin film optical element **F03** has a relatively wide reflection spectrum width of about 5 nm. However, since the oscillation wavelength of a semiconductor laser is determined by gain, the semiconductor laser provided in the present example has a stable single longitudinal mode spectrum.

About 90% of light emitted from the semiconductor laser **F01** which is transmitted through the thin film optical element **F03** excites the Nd:$YVO_4$ **F05.** As a result, laser light (fundamental wave: 1064 nm) oscillates between the Nd:$YVO_4$ **F05** and an output mirror **F06,** and laser light having a wavelength of 1064 nm is obtained through the output mirror **F06.**

Hereinafter, the resonator according to the present example will be described in detail.

An AR coating (reflectance R: 7%) which does not reflect the pump light (wavelength: 809 nm) emitted from the semiconductor laser **F01,** and an HR coating (R > 99.9%) for reflecting light of the oscillation wavelength (1064 nm) are provided on an incident end face **F07** of the Nd:$YVO_4$ (laser medium) **F05.** As a result, the incident end face **F07** of the Nd:$YVO_4$ **F05** functions as a mirror for light of the oscillation wavelength (1064 nm). On the other hand, an AR coating which does not reflect light of the oscillation wavelength (1064 nm) is provided on an outgoing end face **F08** of the Nd:$YVO_4$ **F05.** An HR coating (R > 95%) for reflecting light of the oscillation wavelength (1064 nm) is provided on the output mirror **F06.** Thus, a resonator for the fundamental wave of the oscillation wavelength (1064 nm) is constituted by the output mirror **F06** and the incident end face **F07** of the Nd:$YVO_4$ **F05.**

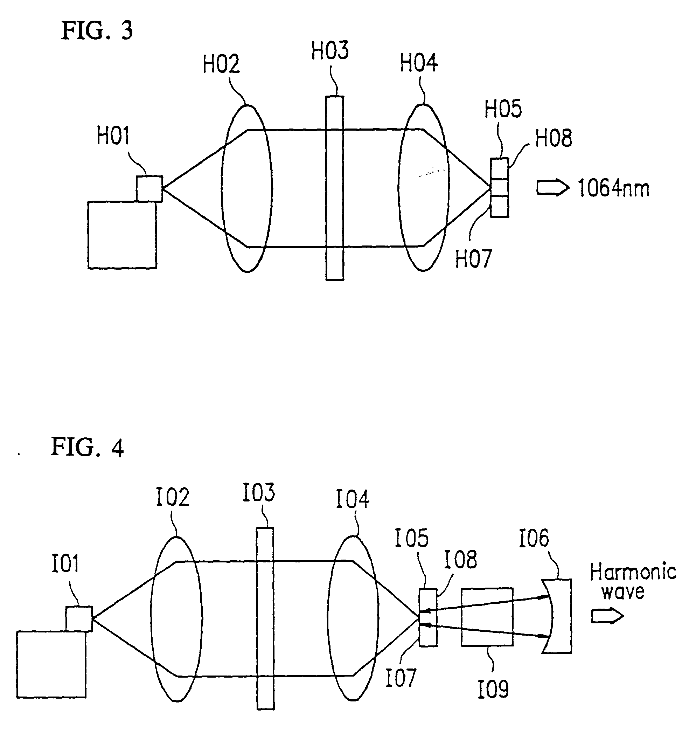

As is described above, an AR coating which does not reflect light of the oscillation wavelength (1064 nm) is provided on the outgoing end face **F08** of the Nd:$YVO_4$ **F05,** and the output mirror **F06** is used in the short wavelength light source apparatus of the present example. However, as is shown in Figure 3 , it is also applicable to provide an HR coating (R > 95%) for reflecting light of the oscillation wavelength (1064 nm) on an outgoing end face **H08** of Nd:$YVO_4$ **H05** without using the output mirror **F06.** Thus, an imaginary output mirror is formed on the outgoing end face **H08** of the Nd:$YVO_4$ **H05,** thereby reducing the length of the resonator. By using a micro-chip laser having a short resonator length, the longitudinal mode of the oscillation wavelength (1064 nm) is also stabilized in a single mode, thus providing a short wavelength light source apparatus with a further stabilized oscillation wavelength.

Although the incident end face **F07** of the Nd: $YVO_4$ **F05** functions as an incident mirror in the present example, it is also applicable to provide a separate incident mirror.

It is also applicable to integrally form the thin film optical element **F03** on the incident end face **F07** or the outgoing end face **F08** of the Nd:$YVO_4$ **F05,** so that the number of the component elements of the short wavelength light source apparatus is reduced, thereby facilitating further miniaturization of the short wavelength light source apparatus. In that case, moreover, the end faces of the Nd:$YVO_4$ **F05** are confocally disposed with the outgoing end face of the semiconductor laser **F01.** Therefore, light reflected by the thin film optical element **F03** can be fed back to the semiconductor laser **F01** even if the thin film optical element **F03** and the optical axis are slightly shifted from a perpendicular position.

Example 2

A short wavelength light source apparatus according to a second example of the present invention will be described with reference to Figure 4 . The short wavelength light source apparatus of the present example incorporates an optical wavelength converting element inserted into the resonator of the short wavelength light source apparatus shown in Figure 1 .

The oscillation wavelength of a semiconductor laser **I01** is stabilized at 809 nm owing to the thin film optical element **I03,** and light transmitted through the thin film optical element **I03** is utilized as pump light for $Nd:YVO_4$ **I05.** KTP ($KTiOPO_4$) **I09** (length: 5 mm) is disposed as an optical wavelength converting element between the $Nd:YVO_4$ **I05** and an output mirror **I06.** Light having a wavelength of 1064 nm oscillating between an incident end face **I07** of the $Nd:YVO_4$ **I05** and the output mirror **I06** is converted into green light having a wavelength of 532 nm by the KTP **I09.**

An AR coating (reflectance R: 7%) which does not reflect the pump light (wavelength: 809 nm) emitted from the semiconductor laser **I01,** and an HR coating (R > 99.9%) for reflecting light of the oscillation wavelength (1064 nm) are provided on the incident end face **I07** of the $Nd:YVO_4$ **I05.** On the other hand, an AR coating which reflects neither light having a wavelength of 1064 nm nor light having a wavelength of 532 nm is provided on an outgoing end face **I08** of the $Nd:YVO_4$ **I05.** An HR coating for reflecting light having a wavelength of 1064 nm is provided on the output mirror **I06.** Thus, a resonator for the fundamental wave (1064 nm) is constituted by the output mirror **I06** and the incident end face **I07** of the $Nd:YVO_4$ **I05.** In cases where wavelength conversion is conducted by means of an optical wavelength converting element as in the present example, the conversion efficiency into a harmonic wave increases as the reflectance for the fundamental wave of a mirror included in the resonator increases. According to the short wavelength light source apparatus of the present example, green light of about 15 mW is obtained, laser light of about 70 mW (pump power) being coupled to the Nd: $YVO_4$ **I05.**

Example 3

Although $Nd:YVO_4$ is used as a laser medium in Examples 1 and 2, similar effects can be obtained by using a laser material doped with Nd (such as Nd:YAG, Nd:GGG, Nd:LN, NYAB, and Nd:YLF) or a tunable laser material doped with Cr, Ti, etc.

Although KTP crystal is used as an optical wavelength converting element in Example 2, wavelength conversion can also be achieved by using other organic or inorganic non-linear optical crystals, or a polarization inversion type bulk element including a substrate composed of $LiTaO_3$(LT), $LiNbO_3$(LN), or $KTiOPO_4$(KTP), thus providing harmonic light.

Example 4

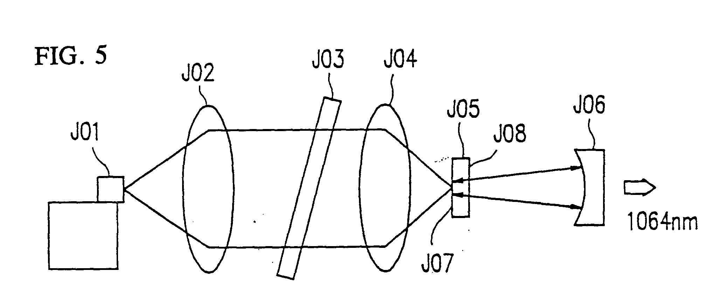

A short wavelength light source apparatus according to a 4 th example of the present invention will be described with reference to Figure 5.

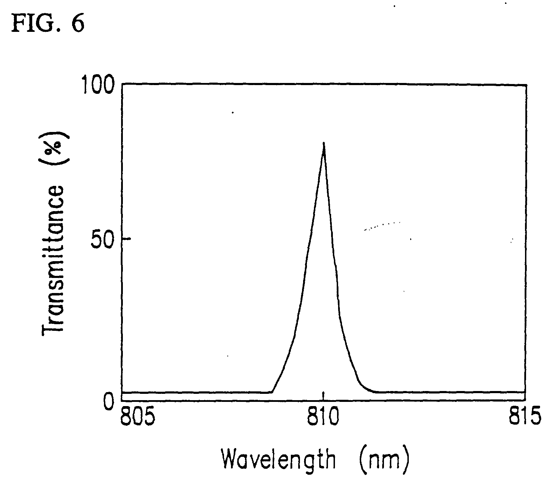

In Figure 5 , reference numeral **J01** denotes a 100 mW-class single longitudinal mode semiconductor laser having an oscillation wavelength in the 810 nm band; **J02** denotes a collimating lens (N.A.: 0.5); **J04** denotes a focusing lens for coupling light to a laser medium $Nd:YVO_4$ **J05;** and **J03** denotes a thin film optical element having transmission spectrum characteristics shown in Figure **6**. A thin film optical element having such transmission spectrum characteristics is referred to as a band-pass type filter. The thin film optical element **J03** is formed by laminating a few dozen layers of a dielectric material, e.g. $TiO_2$, on a glass substrate having a thickness of 0.5 mm. The thin film optical element **J03** has a transmittance of 80% for light having a wavelength of 809 nm, and a transmission spectrum half width of 1 nm. A peak wavelength of the transmission spectrum of a band-pass type filter generally has angle dependence. Figure **6** illustrates a transmission spectrum of a case where the incident light enters at an angle of 20° with the optical axis. The shift amount of the peak wavelength of the transmission spectrum shown in Figure 6 is 1.5 nm/deg. When the incident angle is in the vicinity of 10°, the shift amount is 0.9 nm/deg. When the incident angle is 0°, the peak wavelength makes substantially no shift depending on the angle. As will be appreciated, the shift amount of the transmission spectrum of the band-pass type filter (thin film optical element) **J03** is not so large as compared with an angle dependence of 28 nm/deg, for example, of a grating. Therefore, the adjustment using the thin film optical element **J03** is relatively easy, and the short wavelength light source apparatus is stable against temporal deterioration even if configured as a module. Moreover, the short wavelength light source apparatus of the present example is stable against temperature changes as well (wavelength shift against temperature changes: 0.005 nm/ °C). The short wavelength light source apparatus is also stable against changes in moisture.

Hereinafter, the resonator according to the present example will be described in detail.

An AR coating (reflectance R: 7%) which does not reflect the light having a wavelength of 809 nm, and an HR coating (R > 99.9%) for reflecting light of the oscillation wavelength (1064 nm) are provided on an incident end face **J07** of a laser medium $Nd:YVO_4$ **J05.** On the other hand, an AR coating which does not reflect light of the oscillation wavelength (1064 nm) is provided on an outgoing end face **J08** of the $Nd:YVO_4$ **J05.** An HR coating (R > 95%) for reflecting light of the oscillation wavelength (1064 nm) is provided on an output mirror **J06**. Thus, a resonator for the fundamental wave of the oscillation wavelength (1064 nm) is constituted by the output mirror **J06** and the incident end face **J07** of the Nd:YVO$_4$ **J05.**

Light emitted from the semiconductor laser **J01** and collimated by the collimating lens **J02** is led through the thin film optical element **J03** so as to be focused on the incident end face **J07** of the Nd:YVO$_4$ **J05.** An outgoing end face of the semiconductor laser **J01** is confocally disposed with the incident end face **J07** of the Nd:YVO$_4$ **J05.** As a result, light reflected by the incident end face **J07** of the Nd:YVO$_4$ **J05** is optically fed back to an active layer of the semiconductor laser **J01.** By disposing the thin film optical element **J03** between the semiconductor laser **J01** and the Nd:YVO$_4$ **J05** at an angle of 20° with the optical axis, only light having a wavelength in the vicinity of 809 nm, emitted from the semiconductor laser **J01,** is incident to the incident end face **J07** of the Nd:YVO$_4$ **J05** so as to be reflected thereby, and is optically fed back to the semiconductor laser **J01.** As a result, the semiconductor laser **J01** stably oscillates in a single longitudinal mode, the oscillation wavelength thereof being stabilized in the vicinity of 809 nm.

As is mentioned above, an AR coating is provided on the incident end face **J07** of the Nd:YVO$_4$ **J05.** However, since the AR coating is designed to have the highest reflectance for the fundamental wave of 809 nm, it inevitably has a reflectance on the order of a few % for light having a wavelength in the vicinity of 809 nm, thereby causing return of (reflected) light. The short wavelength light source apparatus of the present example effectively utilizes the returning (reflected) light so as to stabilize the oscillation wavelength of the semiconductor laser.

In the present example, the thin film optical element **J03** is disposed at a certain angle with the optical axis of the semiconductor laser **J01,** as is shown in Figure 5. As a result, the thin film optical element **J03** reflects light having wavelengths other than those in the vicinity of 809 nm. In other words, light having wavelengths other than those in the vicinity of 809 nm is not optically fed back to the active layer of the semiconductor laser **J01.** Thus, the Nd:YVO$_4$ **J05** is excited by the semiconductor laser **J01,** of which oscillation wavelength is stabilized in the vicinity of 809 nm, so that the fundamental wave of 1064 nm oscillates between the incident end face **J07** of the Nd:YVO$_4$ **J05** and the output mirror **J06.** As a result, laser light having wavelength of 1064 nm is obtained through the output mirror **J06.**

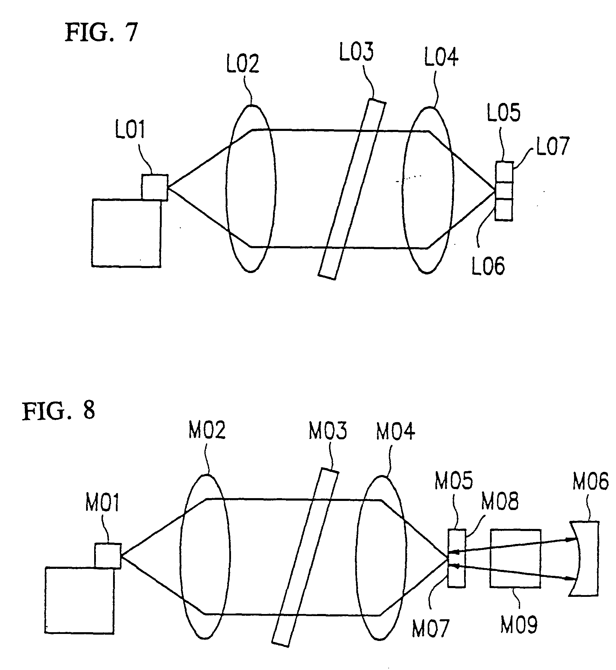

As is described above, an AR coating is provided on the outgoing end face **J08** of the Nd:YVO$_4$ **J05** in the present example. However, as is shown in Figure 7, it is also applicable to provide an output mirror, i.e. an HR coating (R > 95%) for reflecting light of the oscillation wavelength, on an outgoing end face **L08** of a Nd:YVO$_4$ **L05,** so as to provide a micro-chip laser having a short resonator length. Such a micro-chip laser is even more stable because the longitudinal mode of the fundamental wave (1064 nm) is also stabilized as a single mode.

Although an incident mirror (HR coating) is provided on the incident end face **J07** of the Nd:YVO$_4$ **J05** in the present example, it is also applicable to provide a separate incident mirror. The resultant short wavelength light source apparatus would be similarly stable.

Example 5

A short wavelength light source apparatus can also be realized by inserting an optical wavelength converting element into the resonator shown in Figure 5. Figure 8 shows such a short wavelength light source apparatus.

The oscillation wavelength of a semiconductor laser **M01** is stabilized at 809 nm owing to a thin film optical element **M03**, and light transmitted through the thin film optical element **M03** is utilized as pump light for Nd:YVO$_4$ **M05.** KTP (KTiOPO$_4$) **M09** (length: 5 mm) is disposed as an optical wavelength converting element between Nd:YVO$_4$ **M05** and an output mirror **M06.** Light having a wavelength of 1064 nm oscillating between an incident end face **M07** of the Nd:YVO$_4$ **M05** and the output mirror **M06** is converted into green light having a wavelength of 532 nm by the KTP **M09**.

An AR coating (reflectance R: 7%) which does not reflect the pump light (wavelength: 809 nm) emitted from the semiconductor laser **M01,** and an HR coating (R > 99.9%) for reflecting light of the oscillation wavelength (1064 nm) and harmonic light (532 nm) are provided on the incident end face **M07** of the Nd:YVO$_4$ **M05.** On the other hand, an AR coating which reflects neither light having a wavelength of 1064 nm nor light having a wavelength of 532 nm is provided on an outgoing end face **M08** of the Nd:YVO$_4$ **M05.** An HR coating for reflecting light having a wavelength of 1064 nm is provided on the output mirror **M06.** Thus, a resonator for the fundamental wave (1064 nm) is constituted by the output mirror **M06** and the incident end face **M07** of the Nd:YVO$_4$ **M05.** In cases where wavelength conversion is conducted by means of an optical wavelength converting element as in the present example, the conversion efficiency into a harmonic wave increases as the reflectance for the fundamental wave of a mirror included in the resonator increases. According to the short wavelength light source apparatus of the present example, green light of about 15 mW is obtained, laser light of about 70 mW (pump power) being coupled to the Nd:YVO$_4$ **M05.**

Example 6

Although Nd:YVO$_4$ is used as a laser medium in Examples 4 and 5, similar effects can be obtained by using a laser material doped with Nd (such as Nd:YAG, Nd:GGG, Nd:LN, NYAB, and Nd:YLF) or a tunable laser material doped with Cr, Ti, etc.

Although KTP crystal is used as an optical wavelength converting element in Example , wavelength conversion can also be achieved by using other organic or inorganic non-linear optical crystals, or a polarization inversion type bulk element including a substrate composed of $LiTaO_3(LT)$, $LiNbO_3(LN)$, or $KTiOPO_4(KTP)$, thus providing harmonic light.

Example 7

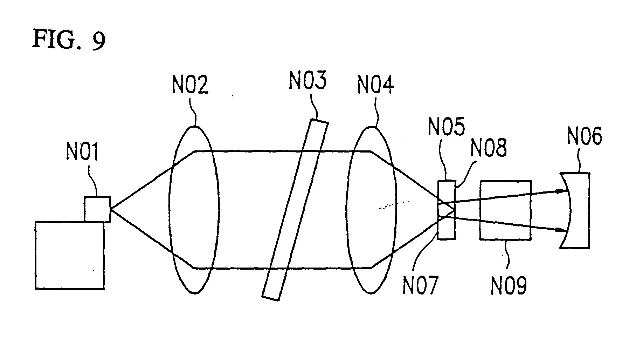

In the short wavelength light source apparatuses shown in Figures 5, 7, and 8 , the stabilization of the oscillation wavelength of the semiconductor laser is achieved by optically feeding back returning light which is reflected by the incident end face of the laser medium Nd:$YVO_4$ to the semiconductor laser. However, the oscillation wavelength can also be stabilized by providing an HR coating (preferably R > 95%) for reflecting light having a wavelength of 809 nm on the outgoing end face of the semiconductor laser so as to feed back light which is not absorbed by the laser oscillation material to the semiconductor laser. Hereinafter, such a short wavelength light source apparatus will be described with reference to Figure 9.

In the case of a material consisting of $YVO_4$ doped with 1% Nd, a thickness of about 1 mm is usually selected for the material; in the case of a material consisting of $YVO_4$ doped with 2% Nd, a thickness of about 0.5 mm is usually selected for the material; in the case of a material consisting of $YVO_4$ doped with 3% Nd, a thickness of about 0.3 mm is usually selected for the material. However, in cases where light reflected by an outgoing end face **N08** of Nd:$YVO_4$ **N05** is utilized, the Nd:$YVO_4$ **N05** must have a thickness smaller than is considered proper. For example, about 80% of the oscillated laser light is absorbed by a material consisting of $YVO_4$ doped with 1% Nd which has a thickness of 0.5 mm, so that a few % of the light is fed back to the semiconductor laser **N01.**

Light emitted from the semiconductor laser **N01** is focused on the outgoing end face **N08** of the Nd:$YVO_4$ **N05** by a focusing lens **N04.** An outgoing end face of the semiconductor laser **N01** is confocally disposed with the outgoing end face **N08** of the Nd:$YVO_4$ **N05.** As a result, light reflected by the outgoing end face **N08** of the Nd:$YVO_4$ **N05** is optically fed back to an active layer of the semiconductor laser **N01,** thereby stabilizing the oscillation wavelength at 809 nm. A thin film optical element **N09** is a band-pass type filter identical with that shown in Figure 5 (which has the transmission spectrum characteristics shown in Figure 6 ).

A thin film optical element **N03** shown in Figure 9 can alternatively be disposed on an incident end face **N07** of the Nd:$YVO_4$ **N05.** In that case, too, only light having a wavelength in the vicinity of 809 nm reflected by the outgoing end face **N08** of the Nd:$YVO_4$ **N05** is fed back to the active layer of the semiconductor laser **N01,** whereby stable excitation of the laser medium Nd:$YVO_4$ **N05** is achieved. In such a configuration, it is preferable to dispose the Nd:$YVO_4$ **N05** at an angle with the optical axis of the semiconductor laser **N01;** in the present example, the Nd:$YVO_4$ **N05** is at an angle of 5° with the optical axis of the semiconductor laser **N01.**

**Example 8**

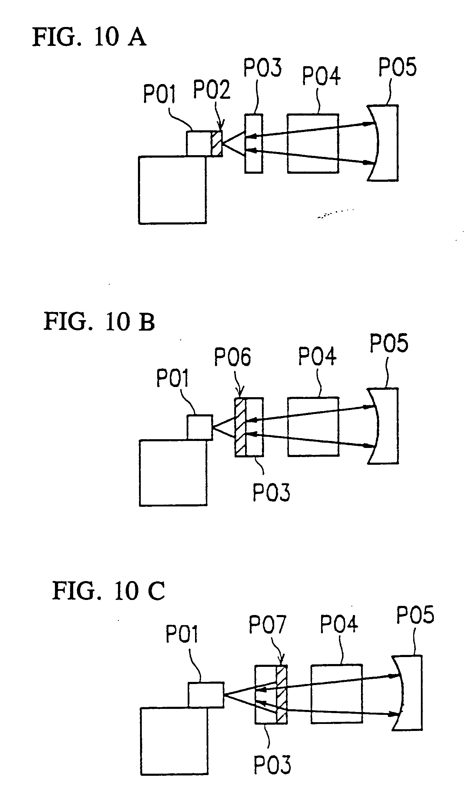

Stabilization of the oscillation wavelength of a semiconductor laser P01, stable wavelength conversion, and high harmonic output power can be provided by: providing a transmission type filter composed essentially of a dielectric multilayer film P02 on an outgoing end face of the semiconductor laser P01 (as is shown in Figure 10A); or providing a transmission type (band-pass-type) or reflective type (band-stop type) filter composed essentially of a dielectric multilayer film on an incident end face (as is shown in Figure 10B) or on an outgoing end face (as is shown in Figure 10C) of Nd:$YVO_4$ P03.

In the configuration shown in Figure 10B, a reflective type filter (thin film optical element) identical with that shown in Figure 1 is provided on the incident end face of the Nd:$YVO_4$ P03 is disposed perpendicularly to the optical axis of the semiconductor laser P01. In the case where a transmission type filter is provided on the incident end face of the Nd:$YVO_4$ P03 , instead of the reflective type filter, light reflected by the outgoing end face of the Nd:$YVO_4$ P03 is utilized as light fed back to the semiconductor laser P01.

In the configuration shown in Figure 10C, a reflective type filter (thin film optical element) is provided on the outgoing end face of the Nd:$YVO_4$ P03, and an optical system is omitted. The semiconductor laser P01 is disposed at a distance of 10 $\mu$m from the Nd:$YVO_4$ P03. The Nd:$YVO_4$ P03 is disposed perpendicularly to the optical axis of the semiconductor laser P01.

Example 9

The oscillation wavelength of a semiconductor laser of a short wavelength light source apparatus according to the present invention can also be stabilized by using a Bragg's reflective type thin film optical element composed essentially of a plurality of periodically formed layers as a reflective type filter.

A method for producing a Bragg's reflective type thin film optical element will be described. $SiO_2$ (refractive index: 1.46), $SiO_2$ having a different composition (refractive index: 1.48) are alternately formed with a period of 0.27 $\mu$m on a quartz substrate by means of an EB vapor deposition apparatus. About 100 such layers are laminated to form the Bragg's reflective type thin film optical element. A Bragg's reflective type thin film optical element is very practical because the spectrum width thereof can be easily adjusted by varying the number of the layers laminated. The oscillation wavelength of a semiconductor laser of a short wavelength light source apparatus incorporating this Braggs's reflective type thin film optical element instead of a bandstop filter is stabilized at the phase matching wavelength or the absorption wavelength. Stable green/blue light is obtained without any mode hopping.

A Bragg's reflective type filter can also be realized by a holographical method where laser light of a predetermined wavelength is incident to a photorefractive material such as LT and LN doped with Fe in two directions so that the two laser light beams interfere with each other.

Example 10

A band-pass type interference filter is capable of achieving a transmittance of about 100% as long as the transmission spectrum width is on the order of a few nm (nanometers). Using a filter having a broad transmission spectrum width for stabilization of the oscillation wavelength would broaden the spectrum width of the semiconductor laser, that is, the semiconductor laser would have a multitude of modes. However, using such a filter with a broad transmission spectrum width is appropriate for high-efficiency excitation because the laser oscillation material has an absorption spectrum width of about a few nm, whereby highly efficient excitation is achieved and the output power of the semiconductor laser can be effectively utilized.

Example 11

Each of the transmission type or reflective type filters shown in Figures 1, 3, 4 , 5, 7, 8, and 9 is a thin film optical element obtained by forming a dielectric multilayer film on a glass substrate having a thickness of 0.5 mm. It has been found out that the oscillation wavelength becomes especially stable when the glass substrate has a thickness in the range of 0.2 mm to 2.0 mm. The oscillation wavelength becomes unstable when the thickness of the substrate is 0.2 mm or less because of the warping of the substrate after polishing. The oscillation wavelength has an aberration when the thickness of the substrate is 2.0 mm or more owing to the thickness of the substrate.

Example 12

In the examples shown in Figures 1, 3, 4, 5, 7, 8, and 9 , a thin film optical element including a dielectric multilayer film formed on a glass substrate is used as an optical element for transmitting or reflecting light in a predetermined wavelength band. The longitudinal mode of the semiconductor laser can also be locked and stabilized by using the following as an optical element: an etalon element including a highly planar element polished so as to be highly planar and so as to have a high degree of parallelism and a reflective film formed on each side of the highly planar element; or a birefringence filter that utilizes interference between normal light and extraordinary light in a birefringence crystal plate.

Hereinafter, an etalon element will be described. Etalon composed of synthetic quartz having a thickness of 50 μm, a reflectance of 85%, and a parallelism of λ/10 is used in the present example. Etalon has peak transmittances at certain intervals when transmittance is regarded as a function of the wavelength of incident light. The interval Δv between modes is derived from the following equation:

$$\Delta v = \lambda^2 / (2nL) \qquad \text{:Eq. 1}$$

wherein n represents the refractive index of the material, and L represents the thickness of the material. In the present example, Δv is 5 nm. Next, finesse F of the etalon is derived. The finesse F is expressed as a ratio between Δv and the half width $\Delta v_{1/2}$ of a certain mode. The finesse F is determined by such factors as reflectance (reflection finesse), degree of planarity and degree of parallelism (planarity finesse), and coarseness of the plane, as is expressed by the following equation:

$$1 / F^2 = (1 / F_r^2) + (1 / F_d^2) \qquad \text{:Eq. 2}$$

wherein $F_r^2$ represents the reflection finesse, and $F_d^2$ represents the planarity finesse. The reflection finesse $F_r^2$ and the planarity finesse $F_d^2$ are expressed by the following equations:

$$F_r^2 = \pi^2 R / (1 - R)^2 \qquad \text{:Eq. 3}$$

$$F_d = S / 2 \qquad \text{:Eq. 4}$$

wherein R represents the reflectance, and S is a value obtained by dividing λ by the degree of parallelism of the etalon. The finesse F of the etalon of the present example is 5. The half width $\Delta v_{1/2}$ of the etalon of the present example is derived to be 1 nm from the following equation:

$$\Delta v_{1/2} = \Delta v / F \qquad \text{:Eq. 5}$$

The value 1 nm of the half width of the etalon of the present example is substantially the same as that of a transmission type filter (thin film optical element). By disposing this etalon between a semiconductor laser and an optical wavelength converting element, the longitudinal mode of the semiconductor laser is stabilized as a single mode. Moreover, the oscillation wavelength of the semiconductor laser becomes stable by increasing the reflectance and the degree of planarity of the etalon so that the half width $\Delta v_{1/2}$ further reduces.

Next, a birefringence filter will be described. An interference pattern can be obtained by radiating light on a crystal panel interposed between two polarizing plates, corresponding to the change in the wavelength of the incident light. By laminating several layers of such composites each composed of a crystal plate interposed between polarizing plates (so that the thickness of the multilayer varies from d to 2d, 4d, .., etc.), the interference patterns overlap with one another so that a sharp peak is left. Thus, a band-pass filter having a transmission spectrum width of about 0.1 nm is realized. The oscillation wavelength of the semiconductor laser can be stabilized also by using such a birefringence filter in the place of a thin film optical element.

As has been described, according to the present invention, a compact, stable, and high-power short wavelength light source apparatus for generating green or blue light is provided which incorporates as a pump light source a light generating device including an optical element for transmitting or reflecting light in a predetermined wavelength band, and a polarization inversion type waveguide element, a polarization inversion type bulk element, and/or a non-linear optical crystal for converting light emitted from the semiconductor laser into light having a different wavelength. A short wavelength light source apparatus according to the present invention is also capable of providing near infrared light by incorporating a laser medium, and providing stable short wavelength light by adopting an intracavity configuration. Thus, the present invention has a large practical significance because it can provide a short wavelength light source apparatus to be used for an optical disk or for measurement purposes, where the short wavelength light source apparatus is required to have a stable, low-noise output power.

Generally, a short wavelength light source apparatus incorporating a semiconductor laser is likely to have the problem of unstable oscillation by the semiconductor laser due to light returning from an end face of an optical wavelength converting element or an end face of a laser medium. However, by using the above-mentioned optical element, light returning (reflected) from such end faces can be utilized for stabilizing the oscillation wavelength of the semiconductor laser, which makes a short wavelength light source apparatus of the present invention very practical. Moreover, the optical component elements can be linearly disposed, thereby facilitating miniaturization of the short wavelength light source apparatus.

A peak wavelength of the transmission spectrum of a transmission type filter (thin film optical element) generally has angle dependence. When the incident light enters at an angle of 20° with the optical axis, the peak wavelength of the transmission spectrum shifts by 1.5 nm/deg. When the incident angle is in the vicinity of 10°, the shift amount is 0.9 nm/deg. When the incident angle is 0°, the peak wavelength makes substantially no shift depending on the angle. Taking advantage of the angle dependence of the filter, the oscillation wavelength of the semiconductor laser can be tuned to be the phase matching wavelength of the optical wavelength converting element. On the other hand, the shift amount of the transmission spectrum of a transmission filter is not so large as compared with that of a grating, e.g. 28 nm/deg. Therefore, using a transmission type filter to stabilize the oscillation wavelength of the semiconductor laser makes the necessary optical adjustment easier than using grating feedback technique. It will be appreciated that use of a transmission type filter (thin film optical element) for stabilization of the oscillation wavelength of the semiconductor laser has great practical effects.

Moreover, a short wavelength light source apparatus according to the present invention is stable against temperature changes, having a wavelength shift of 0.005 nm/°C, and is also stable against changes in moisture. Since it is not composed of resin unlike a grating, the entire short wavelength light source apparatus is made reliable.

Since thin film optical elements are produced by vapor deposition, a mass-production effect is provided, which increases the practicality of the short wavelength light source apparatus.

Even more stable oscillation wavelength (oscillation wavelength locking) can be achieved by incorporating an etalon or a birefringence filter, since the half width of the transmission spectrum of such elements can be reduced to about 0.1 nm.

By providing a rotation mechanism such as a piezo element or a motor (actuator) on the filter and by conducting a feedback so as to stabilize the output power of the short wavelength light, it becomes possible to obtain an output power which is stable against changes in the refractive index due to temperature changes of the optical wavelength converting element and/or optical damage, i.e. changes in the phase matching wavelength, thereby making the short wavelength light source apparatus very practical.

Various other modifications will be apparent to and can be readily made by those skilled in the art without departing from the scope of this invention as defined by the claims.

**Claims**

1. A short wavelength light source apparatus comprising:

    a) a semiconductor laser (F01) including an active layer for emitting laser light;
    b) a laser medium (F05) for receiving at least a portion of the laser light emitted from the semiconductor laser (F01) and for conducting laser oscillation by being excited by at least a portion of the laser light; and
c) an optical element (F03) for selectively reflecting a portion of the laser light that belongs to a predetermined wavelength band while transmitting another portion to the laser medium (F05) and feeding back the reflected portion of the laser light to the active layer of the semiconductor laser (F01) to stabilize its oscillation wavelength within the absorption spectrum of the laser medium, the optical element (F03) being disposed between the semiconductor laser (F01) and the laser medium (F05).

2. A short wavelength light source apparatus according to claim 1, wherein the optical element is a Bragg's reflective type thin film optical element comprising dielectric layers having different refractive indices, the dielectric layers being formed with a predetermined period.

3. A short wavelength light source apparatus according to claim 1, wherein the optical element is a thin film optical element including a substrate and a dielectric multilayer film formed on the substrate.

4. A short wavelength light source apparatus according to claim 1, wherein the optical element comprises a dielectric multilayer film formed on an incident end face or an outgoing end face of at least one of the semiconductor laser and the laser medium.

5. A short wavelength light source apparatus according to one of claims 1 to 4 further comprising more than one optical element besides the optical element.

6. A short wavelength light source apparatus according to one of claims 1 to 5 further comprising an optical wavelength converting element in a cavity.

7. A short wavelenght light source apparatus comprising:

   a) a semiconductor laser (J01) including an active layer for emitting laser light;
   b) a laser medium (J05) for receiving at least a portion of the laser light emitted from the semiconductor laser (J01) and for conducting laser oscillation by being excited by at least a portion of the laser light;
   c) an optical element (J03) for selectively transmitting a portion of the laser light that belongs to a predetermined wavelength band, the optical element (J03) being disposed between the semiconductor laser (J01) and the laser medium (J05), and the semiconductor laser (J01) and the laser medium (J05) being disposed in such a manner that a part of the portion of the laser light transmitted through the optical element (J03) is reflected by an incident end face (J07) of the laser medium (J05) so as to be transmitted back through the optical element (J03) and fed back to the active layer of the semiconductor laser (J01) to stabilize its oscillation wavelength within the absorption spectrum of the laser medium.

8. A short wavelength light source apparatus according to claim 7, wherein the optical element is a thin film optical element including a substrate and a dielectric multilayer film formed on the substrate.

9. A short wavelength light source apparatus according to claim 7, wherein the optical element comprises a dielectric multilayer film formed on an incident end face or an outgoing end face of at least one of the semiconductor laser and the optical wavelength converting element.

10. A short wavelength light source apparatus according to one of claims 7 to 9, wherein the optical element is disposed at an angle with an optical axis of the semiconductor laser.

11. A short wavelength light source apparatus according to one of claims 7 to 10 further comprising a rotation mechanism for rotating the optical element.

12. A short wavelength light source apparatus according to claim 11, wherein the rotation mechanism includes a feedback circuit for controlling an output power of the short wavelength light to be constant.

13. A short wavelength light source apparatus according to claim 11 or 12, wherein the rotation mechanism includes a piezo element.

14. A short wavelength light source apparatus according to claim 11, 12, or 13, wherein the rotation mechanism includes an actuator.

15. A short wavelength light source apparatus according to one of claims 7 to 14 further comprising more than one optical element besides the optical element.

16. A short wavelength light source apparatus according to one of claims 7 to 15 further comprising an optical wavelength converting element in a cavity.

17. A short wavelength light source apparatus comprising:

   a) a semiconductor laser (N01) including an active layer for emitting laser light;

b) a laser medium (N05) for receiving at least a portion of the laser light emitted from the semiconductor laser (N01) and for conducting laser oscillation by being excited by at least a portion of the laser light;

c) an optical element (N03) for selectively transmitting a portion of the laser light that belongs to a predetermined wavelength band, the optical element (N03) being disposed between the semiconductor laser (N01) and the laser medium (N05), and the semiconductor laser (N01) and the laser medium (N05) being disposed in such a manner that a part of the portion of the laser light transmitted through the optical element (N03) enters the laser medium (N05) at the incident end face (N07) thereof and thereafter a portion of said part is reflected by an outgoing end face (N08) of the laser medium (N05) so as to be transmitted back through the optical element (N03) and fed back to the active layer of the semiconductor laser (N01) to stabilize its oscillation wavelength within the absorption spectrum of the laser medium.

18. A short wavelength light source apparatus according to claim 17, wherein the optical element is a thin film optical element including a substrate and a dielectric multilayer film formed on the substrate.

19. A short wavelength light source apparatus according to claim 17, wherein the optical element comprises a dielectric multilayer film formed on an incident end face or an outgoing end face of at least one of the semiconductor laser and the optical wavelength converting element.

20. A short wavelength light source apparatus according to one of claims 17 to 19, wherein the optical element is disposed at an angle with an optical axis of the semiconductor laser.

21. A short wavelength light source apparatus according to one of claims 17 to 20, further comprising a rotation mechanism for rotating the optical element.

22. A short wavelength light source apparatus according to claim 21, wherein the rotation mechanism includes a feedback circuit for controlling an output power of the short wavelength light to be constant.

23. A short wavelength light source apparatus according to claim 21 or 22, wherein the rotation mechanism includes a piezo element.

24. A short wavelength light source apparatus according to claim 21, 22, or 23, wherein the rotation mechanism includes an actuator.

25. A short wavelength light source apparatus according to one of claims 17 to 24 further comprising more than one optical element besides the optical element.

26. A short wavelength light source apparatus according to one of claims 17 to 25 further comprising an optical wavelength converting element in a cavity.

**Patentansprüche**

1. Vorrichtung mit kurzwelliger bzw. Kurzwellen-Lichtquelle mit:

a) einem Halbleiterlaser (F01) mit einer aktiven Schicht zum Emittieren von Laserlicht;
b) einem Lasermedium (F05) zum Empfangen bzw. Aufnehmen mindestens eines Teils des Laserlichts, welches von dem Halbleiterlaser (F01) emittiert wurde und zum Durchführen einer Laser-Oszillation, indem es angeregt wird durch mindestens einen Teil des Laserlichts; und
c) einem optischen Element (F03) zum Selektiven bzw. ausgewählten Reflektieren eines Teils des Laserlichts, welches zu einem vorgegebenen Wellenlängen-Band gehört, wobei bzw. während ein anderer Teil zu dem Lasermedium (F05) gleitet bzw. übertragen wird und zum Rückkoppeln des reflektierten Teiles des Laserlichtes zu der aktiven Schicht des Halbleiterlasers (F01), um dessen Oszillations-Wellenlänge innerhalb des Absorptionsspektrums des Lasermediums zu Stabilisieren, wobei das optische Element (F03) zwischen dem Halbleiterlaser (F01) und dem Lasermedium (F05) angeordnet ist.

2. Vorrichtung mit Kurzwellen-Lichtquelle nach Anspruch 1, wobei das optische Element ein optisches Dünnfilmelement eines reflektierenden Bragg-Typs ist mit dielektrischen Schichten mit verschiedenen Brechungsindizes, wobei die dielektrischen Schichten mit einer vorgegebenen Periode ausgebildet sind.

3. Vorrichtung mit Kurzwellen-Lichtquelle nach Anspruch 1, wobei das optische Element ein optisches Dünnfilmelement ist, mit einem Substrat und einem dielektrischen Mehrschicht-Film, welcher auf dem Substrat ausgebildet ist.

4. Vorrichtung mit Kurzwellen-Lichtquelle nach Anspruch 1, wobei das optische Element einen dielektrischen Mehrschicht-Film aufweist, welcher auf einer Einfalls-Endoberfläche oder einer Austritts-Endoberfläche von mindestens dem Halbleiterlaser oder dem Lasermedium ausgebildet ist.

5. Vorrichtung mit Kurzwellen-Lichtquelle nach einem der Ansprüche 1 bis 4, weiter aufweisend mehr als ein optisches Element neben dem optischen Element.

6. Vorrichtung mit Kurzwellen-Lichtquelle nach einem der Ansprüche 1 bis 5, weiter aufweisend ein optisches Element zum Umwandeln einer Wellenlänge in einem Hohlraum.

7. Vorrichtung mit Kurzwellen-Lichtquelle mit:

a) einem Halbleiter-Laser (J01) mit einer aktiven Schicht zum Emittieren von Laserlicht;
b) einem Lasermedium (J05) zum Empfangen bzw. Aufnehmen von mindestens einem Teil des Laserlichts, welches von dem Halbleiterlaser (J01) emittiert wurde und zum Durchführen einer Laser-Oszillation, indem es durch mindestens einen Teil des Laserlichtes angeregt wird bzw. wurde;
c) einem optischen Element (J03) zum selektiven bzw. ausgewählten Übertragen bzw. Weiterleiten eines Teils des Laserlichts, welches zu einem vorgegebenen Wellenlängen-Band gehört, wobei das optische Element (J03) zwischen dem Halbleiter-Laser (J01) und dem Lasermedium (J05) angeordnet ist, und der Halbleiter-Laser (J01) und das Lasermedium (J05) sind auf eine solche Art angeordnet, dass ein Teil des Teils des Laserlichts, welches durch das optische Element (J03) übertragen bzw. geleitet wird, reflektiert wird durch bzw. an einer Einfalls-Endoberfläche (J07) des Lasermediums (J05) um so zurück übertragen bzw. geleitet zu werden durch das optische Element (J03) und zurückgekoppelt zu werden zu der aktiven Schicht des Halbleiterlasers (J01) um deren Oszillationswellenlänge innerhalb des Absorptionsspektrums des Lasermediums zu stabilisieren.

8. Vorrichtung mit Kurzwellen-Lichtquelle nach Anspruch 7, wobei das optische Element ein optisches Dünnfilmelement ist mit einem Substrat und einem dielektrischen Mehrschichtfilm, welcher auf dem Substrat ausgebildet ist.

9. Vorrichtung mit Kurzwellen-Lichtquelle nach Anspruch 7, wobei das optische Element einen dielektrischen Mehrschicht-Film aufweist, welcher auf einer Einfalls-Endoberfläche oder einer Austritts-Endoberfläche von mindestens dem Halbleiterlaser oder dem optischen Element zum Umwandeln der Wellenlänge ausgebildet ist.

10. Vorrichtung mit Kurzwellen-Lichtquelle nach einem der Ansprüche 7 bis 9, wobei das optische Element bei bzw. mit einem Winkel bezüglich einer optischen Achse des Halbleiterlasers angeordnet ist.

11. Vorrichtung mit Kurzwellen-Lichtquelle nach einem der Ansprüche 7 bis 10, weiter aufweisend einen Drehmechanismus zum Drehen des optischen Elements.

12. Vorrichtung mit Kurzwellen-Lichtquelle nach Anspruch 11, wobei der Drehmechanismus einen Rückkopplungsschaltkreis aufweist zum Regeln bzw. Steuern einer Ausgangsleistung des kurzwelligen Lichtes, so dass diese konstant ist.

13. Vorrichtung mit Kurzwellen-Lichtquelle nach Anspruch 11 oder 12, wobei der Drehmechanismus ein Piezo-Element umfasst.

14. Vorrichtung mit Kurzwellen-Lichtquelle nach Anspruch 11, 12, oder 13, wobei der Drehmechanismus ein Stellglied bzw. einen Aktuator umfasst.

15. Vorrichtung mit Kurzwellen-Lichtquelle nach einem der Ansprüche 7 bis 14, weiter umfassend mehr als ein optisches Element neben dem optischen Element.

16. Vorrichtung mit Kurzwellen-Lichtquelle nach einem der Ansprüche 7 bis 15, weiter aufweisend ein optisches Element zum Umwandeln einer Wellenlänge in einem Hohlraum.

17. Vorrichtung mit Kurzwellen-Lichtquelle mit:

a) einem Halbleiterlaser (N01) mit einer aktiven Schicht zum Emittieren von Laserlicht;
b) einem Lasermedium (N05) zum Empfangen bzw. Aufnehmen mindestens eines Teils des Laserlichts, welches von dem Halbleiterlaser (N01) emittiert wurde und zum Durchführen einer Laser-Oszillation, indem es angeregt wird durch mindestens einen Teil des Laserlichts; und
c) einem optischen Element (N03) zum selektiven Übertragen bzw. Leiten eines Teils des Laserlichtes, welches zu einem vorgegebenen Wellenlängen-Band gehört, wobei das optische Element (N03) zwischen dem Halbleiterlaser (N01) und dem Lasermedium (N05) angeordnet ist, und der Halbleiterlaser (N01) und das Lasermedium (N05) sind auf eine solche Art angeordnet, dass ein Teil des Teils des Laserlichtes, welches durch das optische Element (N03) übertragen bzw. geleitet wird, in das Lasermedium (N05) bei der Eintritts- bzw. Einfalls-Endoberfläche (N07) davon eintritt und danach wird ein Teil des Teiles reflektiert durch bzw. an einer Austritts-Endoberfläche (N08) des Lasermediums (N05), um so zurückübertragen bzw. geleitet zu werden durch das optische Element (N03) und zurückgekoppelt zu werden zu der aktiven Schicht des Halbleiterlasers (N01), um dessen Oszillations-Wellenlänge innerhalb des Absorptions-Spektrums des Lasermediums zu stabilisieren.

18. Vorrichtung mit Kurzwellen-Lichtquelle nach Anspruch 17, wobei das optische Element ein optisches Dünnfilmelement ist mit einem Substrat und einem dielektrischen Mehrschichtfilm, welcher auf dem Substrat ausgebildet ist.

19. Vorrichtung mit Kurzwellen-Lichtquelle nach Anspruch 17, wobei das optische Element einen dielektrischen Mehrschicht-Film aufweist, welcher auf einer Einfalls-Endoberfläche oder einer Austritts-Endoberfläche von mindestens dem Halbleiterlaser oder dem optischen Element zum Umwandeln der Wellenlänge ausgebildet ist.

20. Vorrichtung mit Kurzwellen-Lichtquelle nach einem der Ansprüche 17 bis 19, wobei das optische Element bei bzw. mit einem Winkel bezüglich einer optischen Achse des Halbleiterlasers angeordnet ist.

21. Vorrichtung mit Kurzwellen-Lichtquelle nach einem der Ansprüche 17 bis 20, weiter aufweisend einen Drehmechanismus zum Drehen des optischen Elements.

22. Vorrichtung mit Kurzwellen-Lichtquelle nach Anspruch 21, wobei der Drehmechanismus einen Rückkopplungsschaltkreis aufweist zum Regeln bzw. Steuern einer Ausgangsleistung des kurzwelligen Lichtes, so dass diese konstant ist.

23. Vorrichtung mit Kurzwellen-Lichtquelle nach Anspruch 21 oder 22, wobei der Drehmechanismus ein Piezo-Element umfasst.

24. Vorrichtung mit Kurzwellen-Lichtquelle nach Anspruch 21, 22, oder 23, wobei der Drehmechanismus ein Stellglied bzw. einen Aktuator umfasst.

25. Vorrichtung mit Kurzwellen-Lichtquelle nach einem der Ansprüche 17 bis 24, weiter umfassend mehr als ein optisches Element neben dem optischen Element.

26. Vorrichtung mit Kurzwellen-Lichtquelle nach einem der Ansprüche 17 bis 25, weiter aufweisend ein optisches Element zum Umwandeln einer Wellenlänge in einem Hohlraum.

**Revendications**

1. Dispositif de source de lumière à courte longueur d'onde comprenant :

   a) un laser à semiconducteur (F01) comprenant une couche active destinée à émettre une lumière laser,
   b) un milieu de laser (F05) destiné à recevoir au moins une partie de la lumière laser émise à partir du laser à semiconducteur (F01) et à exécuter une oscillation du laser en étant excité par au moins une partie de la lumière laser, et
   c) un élément optique (F03) destiné à réfléchir sélectivement une partie de la lumière laser qui appartient à une bande de longueurs d'onde prédéterminée tout en transmettant une autre partie vers le milieu de laser (F05) et renvoyer la partie réfléchie de la lumière laser vers la couche active du laser à semiconducteur (F01) afin de stabiliser sa longueur d'onde d'oscillation à l'intérieur du spectre d'absorption du milieu de laser, l'élément optique (F03) étant disposé entre le laser à semiconducteur (F01) et le milieu de laser (F05).

2. Dispositif de source de lumière à courte longueur d'onde selon la revendication 1, dans lequel l'élément optique est un élément optique à film mince du type à réflexion de Bragg comprenant des couches diélectriques présentant des indices de réfraction différents, les couches diélectriques étant formées avec une période prédéterminée.

3. Dispositif de source de lumière à courte longueur d'onde selon la revendication 1, dans lequel l'élément optique est un élément optique à film mince comprenant un substrat et un film diélectrique à couches multiples formé sur le substrat.

4. Dispositif de source de lumière à courte longueur d'onde selon la revendication 1, dans lequel l'élément optique comprend un film diélectrique à couches multiples formé sur une face d'extrémité d'incidence ou une face d'extrémité d'émergence d'au moins l'un du laser à semiconducteur et du milieu de laser.

5. Dispositif de source de lumière à courte longueur d'onde selon l'une des revendications 1 à 4, comprenant en outre plus d'un élément optique en dehors de l'élément optique.

6. Dispositif de source de lumière à courte longueur d'onde selon l'une des revendications 1 à 5, comprenant en outre un élément de conversion de longueur d'onde optique dans une cavité.

**7.** Dispositif de source de lumière à courte longueur d'onde comprenant :

a) un laser à semiconducteur (J01) comprenant une couche active destinée à émettre une lumière laser,
b) un milieu de laser (J05) destiné à recevoir au moins une partie de la lumière laser émise depuis le laser à semiconducteur (J01) et destiné à exécuter une oscillation du laser en étant excité par au moins une partie de la lumière laser, et
c) un élément optique (J03) destiné à transmettre sélectivement une partie de la lumière laser qui appartient à une bande de longueurs d'onde prédéterminée, l'élément optique (J03) étant disposé entre le laser à semiconducteur (J01) et le milieu de laser (J05), et le laser à semiconducteur (J01) et le milieu de laser (J05) étant disposés de telle manière qu'une partie de la partie de la lumière laser transmise au travers de l'élément optique (J03) est réfléchie par une face d'extrémité d'incidence (J07) du milieu de laser (J05) de façon à être transmise en retour au travers de l'élément optique (J03) et renvoyée vers la couche active du laser à semiconducteur (J01) afin de stabiliser sa longueur d'onde d'oscillation à l'intérieur du spectre d'absorption du milieu de laser.

**8.** Dispositif de source de lumière à courte longueur d'onde selon la revendication 7, dans lequel l'élément optique est un élément optique à film mince comprenant un substrat et un film diélectrique à couches multiples formé sur le substrat.

**9.** Dispositif de source de lumière à courte longueur d'onde selon la revendication 7, dans lequel l'élément optique comprend un film diélectrique à couches multiples formé sur une face d'extrémité d'incidence ou une face d'extrémité d'émergence d'au moins l'un du laser à semiconducteur et de l'élément de conversion de longueur d'onde optique.

**10.** Dispositif de source de lumière à courte longueur d'onde selon l'une des revendications 7 à 9, dans lequel l'élément optique est disposé suivant un angle par rapport à un axe optique du laser à semiconducteur.

**11.** Dispositif de source de lumière à courte longueur d'onde selon l'une des revendications 7 à 10, comprenant en outre un mécanisme de rotation destiné à faire tourner l'élément optique.

**12.** Dispositif de source de lumière à courte longueur d'onde selon la revendication 11, dans lequel le mécanisme de rotation comprend un circuit de contre-réaction destiné à commander une puissance d'émission de la lumière à courte longueur d'onde pour qu'elle soit constante.

**13.** Dispositif de source de lumière à courte longueur d'onde selon la revendication 11 ou 12, dans lequel le mécanisme de rotation comprend un élément piézoélectrique.

**14.** Dispositif de source de lumière à courte longueur d'onde selon la revendication 11, 12 ou 13, dans lequel le mécanisme de rotation comprend un actionneur.

**15.** Dispositif de source de lumière à courte longueur d'onde selon l'une des revendications 7 à 14, comprenant en outre plus d'un élément optique en dehors de l'élément optique.

**16.** Dispositif de source de lumière à courte longueur d'onde selon l'une des revendications 7 à 15, comprenant en outre un élément de conversion de longueur d'onde optique dans une cavité.

**17.** Dispositif de source de lumière à courte longueur d'onde comprenant :

a) un laser à semiconducteur (N01) comprenant une couche active destinée à émettre une lumière laser,
b) un milieu de laser (N05) destiné à recevoir au moins une partie de la lumière laser émise depuis le laser à semiconducteur (N01) et à exécuter une oscillation de laser en étant excité par au moins une partie de la lumière laser,
c) un élément optique (N03) destiné à transmettre sélectivement une partie de la lumière laser qui appartient à une bande de longueurs d'onde prédéterminée, l'élément optique (N03) étant disposé entre le laser à semiconducteur (N01) et le milieu de laser (N05), et le laser à semiconducteur (N01) et le milieu de laser (N05) étant disposés de telle manière qu'une partie de la partie de la lumière laser transmise au travers de l'élément optique (N03) pénètre dans le milieu de laser (N05) au niveau de la face d'extrémité d'incidence (N07) de celui-ci et ensuite une partie de ladite partie est réfléchie par une face d'extrémité d'émergence (N08) du milieu de laser (N05) de façon à être transmise en retour au travers de l'élément optique (N03) et renvoyée vers la couche active du laser à semiconducteur (N01) afin de stabiliser sa longueur d'onde d'oscillation à l'intérieur du spectre d'absorption du milieu de laser.

**18.** Dispositif de source de lumière à courte longueur d'onde selon la revendication 17, dans lequel l'élément optique est un élément optique à film mince comprenant un substrat et un film de diélectrique à couches multiples formé sur le substrat.

**19.** Dispositif de source de lumière à courte longueur d'onde selon la revendication 17, dans lequel l'élément optique comprend un film diélectrique à couches multiples formé sur une face d'extrémité d'incidence ou une face d'extrémité d'émergence d'au moins l'un du laser à semiconducteur et de l'élément de conversion de longueur d'onde optique.

**20.** Dispositif de source de lumière à courte longueur d'onde selon l'une des revendications 17 à 19, dans lequel l'élément optique est disposé suivant un angle par rapport à un axe optique du laser à semiconducteur.

**21.** Dispositif de source de lumière à courte longueur d'onde selon l'une des revendications 17 à 20, comprenant en outre un mécanisme de rotation destiné à faire tourner l'élément optique.

**22.** Dispositif de source de lumière à courte longueur d'onde selon la revendication 21, dans lequel le mécanisme de rotation comprend un circuit de contre-réaction destiné à commander une puissance d'émission de la lumière à courte longueur d'onde pour qu'elle soit constante.

**23.** Dispositif de source de lumière à courte longueur d'onde selon la revendication 21 ou 22, dans lequel le mécanisme de rotation comprend un élément piézoélectrique.

**24.** Dispositif de source de lumière à courte-longueur, d'onde selon la revendication 21, 22 ou 23, dans lequel le mécanisme de rotation comprend un actionneur.

**25.** Dispositif de source de lumière à courte longueur d'onde selon l'une des revendications 17 à 24, comprenant en outre plus d'un élément optique en dehors de l'élément optique.

**26.** Dispositif de source de lumière à courte longueur d'onde selon l'une des revendications 17 à 25, comprenant en outre un élément de conversion de longueur d'onde optique dans une cavité.

FIG. 1

FIG. 2

FIG. 3

$\Rightarrow$ 1064nm

FIG. 4

Harmonic
wave
$\Rightarrow$

FIG. 5

1064nm

FIG. 6

FIG. 7

FIG. 8

FIG. 9

FIG. 10 A

P01 P02 P03 P04 P05

FIG. 10 B

P01 P06 P04 P05

P03

FIG. 10 C

P01 P07 P04 P05

P03

FIG. 11

EP 0 738 031 B1

FIG. 12

Optical
polarization
direction

26